(19) Europäisches Patentamt

European Patent Office

Office européen des brevets

(11) **EP 1 323 231 B1**

(12) **EUROPEAN PATENT SPECIFICATION**

(45) Date of publication and mention
of the grant of the patent:
**28.06.2006 Bulletin 2006/26**

(51) Int Cl.:
*H03F 3/217* (2006.01)    *H03F 1/32* (2006.01)

(21) Application number: **01985293.8**

(22) Date of filing: **19.09.2001**

(86) International application number:
**PCT/IB2001/002733**

(87) International publication number:
**WO 2002/025357 (28.03.2002 Gazette 2002/13)**

(54) **CONTROLLED SELF-OSCILLATION MODULATOR AND POWER CONVERSION SYSTEM USING SUCH A MODULATOR**

MODULATOR MIT GESTEUERTER SELBSTOSZILLATION UND LEISTUNGSUMSETZUNGSSYSTEM MIT EINEM SOLCHEN MODULATOR

MODULATEUR A AUTO-OSCILLATION CONTROLEE ET SYSTEME DE CONVERSION DE PUISSANCE UTILISANT UN TEL MODULATEUR

(84) Designated Contracting States:
**AT BE CH CY DE DK ES FI FR GB GR IE IT LI LU MC NL PT SE TR**

(30) Priority: **19.09.2000 SE 0003342**

(43) Date of publication of application:
**02.07.2003 Bulletin 2003/27**

(73) Proprietor: **Bang & Olufsen Ice Power A/S
7600 Struer (DK)**

(72) Inventor: **NIELSEN, Karsten
DK-2800 Kgl Lyngby (DK)**

(74) Representative: **Lind, Urban Arvid Oskar
AWAPATENT AB,
P.O. Box 11394
404 28 Göteborg (SE)**

(56) References cited:
**WO-A1-97/15170**          **WO-A2-98/19391**
**WO-A2-98/44626**          **US-A- 4 531 096**

• **NAM-SUNG JUNG; JAE-HOON JEONG; GYU-HYEONG CHO: 'A Dual Loop Feedback Audio Amplifier Using Self-oscillating Delta Modulation' CONFERENCE PROCEEDINGS ARTICLE 11 June 1997, pages 304 - 305, XP010250067**

**Description**

Technical field

This invention relates to a self-oscillating modulator, comprising a comparator and a power amplification stage for pulse modulation, and a higher order oscillating loop comprising first feedback means and first forward means securing stable oscillating conditions, wherein said first feedback means is arranged to supply a first feedback signal to said first forward means, which is arranged to provide a modulating signal to said comparator.

The invention also relates to a switching power conversion system, such as DC-AC (e.g. audio amplification), DC-DC or AC-AC conversion systems using such a modulator. The invention may advantageously be used for improved power conversion in any system, in particular precision DC-AC conversion systems as high efficiency audio amplification.

Technical background

The pulse modulator is a central element of any power conversion system. Most switching power converters are based on Pulse Width Modulation (PWM) as a means to control efficient conversion between domains (DC or AC).

A typical power converter includes a PWM modulator, a switching power conversion stage, a filter and a control system. A prior art system of this type is described in US Patent. No. 4724396 (1988) and by Mr. Attwood in Journal of the AES, Nov. 1983. p. 842-853. However, PWM has a range of shortcomings also well known to the art, mainly due to the implementation of the carrier generation. This limits the system bandwidth and complicates design. Also, a stable and robust control system design is difficult.

In order to overcome these drawbacks, a controlled self-oscillating modulator (COM) was introduced in the applicant's international patent application PCT/DK97/00497. The disclosed modulator eliminates the need of a carrier generator, with a range of advantages, described in detail in said document.

A problem with this technique is that voluminous and expensive power components are needed, in order to compensate for filter inductor currents. Further, problems may occur when the modulator is connected to a reactive load or open load, requiring e.g. RC-Zobel compensation. The COM technology is also difficult to implement in systems with greater bandwidth. In short, it could be said that even though the COM approach overcomes some of the disadvantages of the conventional PWM technology, some limitations are still present.

Other self-oscillating modulators are known from Japanese Patent no. 56039606 and from the IEEE article "A Dual Loop Feedback Audio Amplifier using Self-oscillating Delta Modulation", by Nam-Sung Jung et al, 1997.

Objects of the invention

Accordingly, a primary object of the invention has been to provide a superior modulation technique in switching power conversion systems that overcomes fundamental problems related to conventional techniques.

A second object has been to provide a pulse modulation in general power conversion systems that provides significant advantages in performance, topological simplification, improved robustness and stability compared to prior art.

Summary of the invention

These objects are achieved by a controlled self-oscillating modulator (COM) of the type mentioned above, characterized by current measurement means, arranged to measure a value of a current supplied by said power amplification stage to a load connected to the modulator, said measured value being supplied to said first feedback means, wherein said first feedback means has a transfer function adapted to generate said first feedback signal based on said measured value, and said first forward means has a transfer function adapted to generate said modulating signal based on said first feedback means and an input signal.

By measuring the current that is supplied to the load, the load control is much improved, eliminating the need of further load compensation. Also, any filter inductor currents are compensated, as the modulator acts as a powerful, wideband control system, leading to lower requirements on the power components.

As the current measurement itself implements a first order transfer function, and thus introduces a first pole in the oscillating loop, this leads to a simplification of the design. Especially in applications where miniaturization is important, such as mobile, personal audio equipment, this is an important advantage over

prior art.

The COM according to the invention thus aims to combine the advantages of the COM technology with the advantages of current controlled PWM technology, resulting in a system presenting the following features:

- The system is inherently unstable
- No carrier generator is needed, saving components.
- The power supply variable $V_s$ is eliminated from the effective loop transfer function.
- The system acts as a wideband control system.
- Clean modulation (no feedback noise and poor carrier signal).
- A controllable variable switching frequency for improved efficiency and EMI.

This makes the modulator according to the invention very suitable in all types of precision DC-AC conversion applications, such as audio applications.

The modulator preferably includes means for feedback of an output voltage from said amplification stage. This enables a very compact design combining modulation and control system surrounding the central power conversion stage. Whereas combined voltage and current feedback PWM systems are well known in the art, said COM based two loop topology is an advantageous improvement and new to the art.

According to an embodiment of the voltage feedback, the first feedback means is connected to said output voltage, and the first feedback means is adapted to generate said first feedback signal based on said current value and said voltage. This can be an advantageous way to implement the double feedback, reducing the number of components.

According to another embodiment of the voltage feedback, the modulator comprises a second feedback means connected to said output voltage, and adapted to generate a second feedback signal, and a second forward means, adapted to supply said first forward block with said input signal based on said second feedback signal and a second signal. Although this implementation is somewhat more complex, it can be advantageous in some applications, where it is desirable to let the current measurement and the voltage feedback with different transfer functions.

The power amplification stage can comprise an output filter, and the second feedback means can then be connected to an output from said output filter. This permits a first filtering of the voltage before it is fed back in the feedback path.

In a preferred embodiment, the means for current measurement is adapted to implement protection functions as limitations of peak current and long term current.

The controlled oscillation modulator can advantageously be used in precision voltage or current controlled DC-AC conversion as e.g. power amplifiers for audio use.

Brief description of the drawings

Preferred embodiments of the present invention will be further described in the following, with reference to the appended drawings.

Fig. 1 shows a prior art controlled oscillating modulator based on voltage feedback.
Fig. 2 shows a block diagram of a first embodiment of the invention.
Fig. 3 shows a block diagram of a second embodiment of the invention.
Fig. 4 shows a block diagram of a third embodiment of the invention.

Detailed description of the preferred embodiments

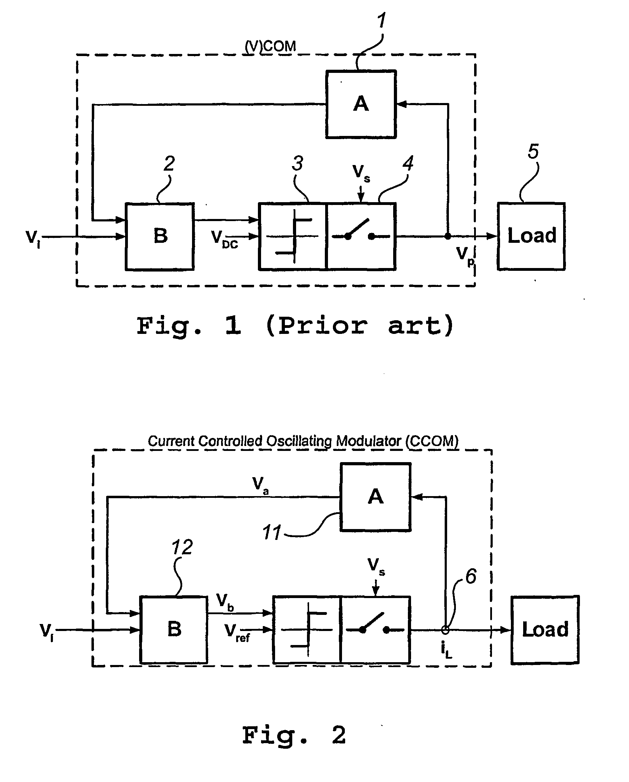

The basic principle of the COM according to prior art is illustrated in the general block diagram of Fig. 1. As it uses voltage feedback, it will be referred to as VCOM. An input voltage $V_i$ is supplied to a forward block 2, also supplied by a feedback block 1, to derive and process error information. The compensated signal $V_b$ is supplied to a non-hysteresis comparator 3, which is referenced to a voltage $V_{DC}$, preferably a DC voltage. The resulting pulse modulated signal is power amplified in a switching power conversion stage 4 supplied by $V_s$, generation the power pulse signal $V_p$, said pulse signal driving an inductive load 5.

The block 1 processes output information from the output voltage $V_p$ and controls the overall transfer function characteristics of the system. The controlled oscillation modulator is characterized by at least two poles total in the blocks 1 and 2, in combination with the propagation delay of the modulator and power stage generating a sinusoidal like modulating signal $V_b$ to be compared with $V_{DC}$. Under these presumptions, the system realizes an oscillating system at the frequency of positive feedback. The block 1 is implemented to control the overall transfer function characteristics from $V_i$ to the output variables.

Assuming, that a constant gain $K$ is desired over a certain bandwidth, it proves expedient with the following transfer functions:

$$A(s) = \frac{1}{K}\frac{1}{\tau_1 s + 1}\frac{1}{\tau_o s + 1} \qquad B(s) = K_B\frac{\tau_{zB}s + 1}{\tau_{pB}s + 1}\frac{1}{\tau_o s + 1} \qquad (1)$$

In this illustrative example, the A-block 1 having a first order characteristic with a pole $s = -1/\tau_1$ placed at lower frequencies, generally more than a decade below the oscillation frequency, the oscillation conditions are comfortably determined by $\tau_0$ with the two poles placed at $s = -1/\tau_0$. The requirements for a " Controlled Oscillation Modulation (COM) " is:

$$|L(j\omega_o)| = |K_P A(j\omega_o)B(j\omega_o)| = 1 \quad \wedge \quad \prec L(j\omega_o) = 180^o \qquad (2)$$

where the desired system oscillation frequency is $\omega_0$. Hence, in this preferred example, the condition for controlled oscillation is:

$$|K_B K_P| = K\frac{\omega_o \tau_{p1}\tau_{pB}}{2\tau_{zB}} \qquad (3)$$

The VCOM system will be forced to oscillate at $\omega_0$ due to the non-linear gain characteristic of the comparator and a switching power stage.

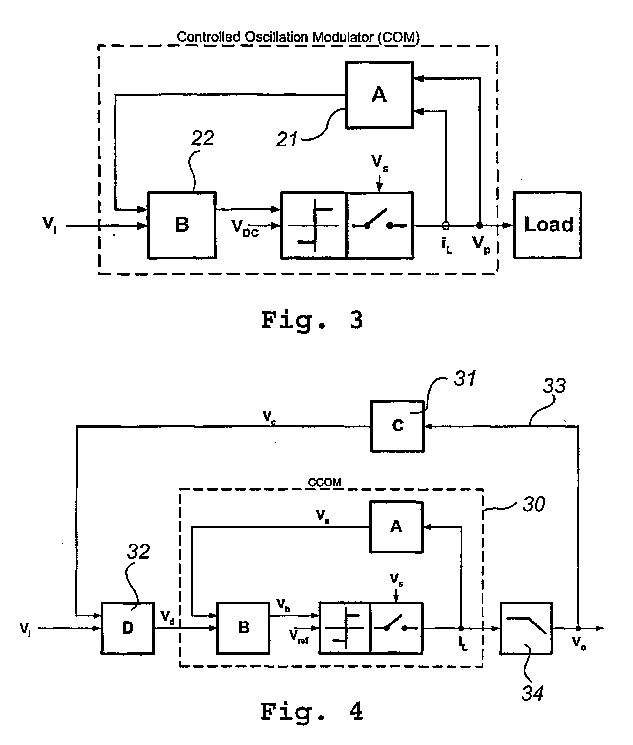

As a preferred embodiment of the invention consider the system in fig. 2. In this modulator, it is the value of the current $i_L$ delivered to the load that is used as input in the generation of a modulating signal $V_b$. The current $i_L$ is measured with a current measurement means 6, arranged after the amplification stage 4.

Advantageous transfer functions of the blocks 11 and 12 in this case are:

$$A(s) = Z_m\frac{1}{\tau_o s + 1} \qquad B(s) = K_B\frac{\tau_{zB}s + 1}{\tau_{pB}s + 1}\frac{1}{\tau_o s + 1} \qquad (4)$$

Assuming that the current controlled COM system, henceforth referred to as CCOM, is loaded by a second order (L,C) filter for demodulation, the loop transfer function is:

$$G_C(s) = A(s)B(s)G_O(s) \qquad (5)$$

$$= K_B\frac{\tau_{zB}s + 1}{\tau_{pB}s + 1} \cdot \frac{K_P(\hat{v}_b)}{L}\frac{s + \dfrac{\omega_0}{Q_o}}{s^2 + \dfrac{\omega_0}{Q_o}s + \omega_o^2}Z_m\frac{1}{(\tau_o s + 1)^2}$$

Where:

$$\omega_0 = \frac{1}{\sqrt{LC}}, \qquad Q_o = R\sqrt{\frac{C}{L}} = RC\omega_0 \qquad (6)$$

Hence, the condition for controlled oscillation in the CCOM system is:

$$\left|K_B K_P\right| = \frac{L}{Z_m} \frac{\omega_o \tau_{pB}}{2\tau_{zB}} \tag{7}$$

Example parameter values for the CCOM system are:

| Parameter | Nom. Frequency (rel. to bandwidth) | Audio Case |
|---|---|---|
| $f_{zB} = \dfrac{1}{2\pi\tau_{zB}}$ | 2 | 40kHz |
| $f_{pB} = \dfrac{1}{2\pi\tau_{pB}}$ | 0.2 | 4kHz |
| $f_o$ | 20 | 400kHz |

Those skilled in the art will appreciate that many well known ways could be used to implement the CCOM system with alternative parameters and alternative placement of the poles. Thus, the example is only illustrative and demonstrating a simple broad band transconductance amplifier system with a constant in-band transconductance of $\dfrac{1}{Z_m}$.

The CCOM modulator illustrated in fig 2 can advantageously be combined with the VCOM according to prior art, and two preferred embodiments of this combination are illustrated in fig 3 and 4.

This combined modulator may advantageously be implemented in a general purpose high performance DC-AC conversion system, with a 2:nd order demodulation filter and a global voltage loop.

In fig 3, the transfer function A' of feedback block 21 is adapted to receive a voltage feedback from the amplification stage 4 as well as the measured current value $i_L$. Suitable adjustment of the transfer function B' of forward block 22 is also made.

Another example is the broadband, constant gain power amplifier of fig 4, where two additional blocks 31 and 32 have been introduced. The amplifier thus comprises a CCOM 30 according to fig 2, surrounded by a voltage feedback path 33. The voltage signal $V_o$ is taken after an output filter 34, and is connected to the block 31. The generated signal $V_c$ is then supplied to the block 32, also supplied with the input voltage $V_i$. It is the output from block 32 which is supplied to the forward block 11 of the CCOM 30, together with the signal $V_a$ from the feedback block 12. Preferred transfer functions of the blocks 31 and 32 are:

$$C(s) = \frac{1}{K} \frac{1}{\tau_{pC}s + 1} \qquad D(s) = K_D \frac{\tau_{zD}s + 1}{\tau_{pD}s + 1} \tag{8}$$

By adjusting $K_D$ the desired voltage loop bandwidth, $f_v$, is easily implemented. Example parameters are:

| Parameter | Nom. Frequency (rel. To bandwidth) | Audio Case |
|---|---|---|
| $f_{zD} = \dfrac{1}{2\pi\tau_{zD}}$ | 2 | 40kHz |
| $f_{pD} = \dfrac{1}{2\pi\tau_{DB}}$ | 0.2 | 4kHz |

Table continued

| Parameter | Nom. Frequency (rel. To bandwidth) | Audio Case |
|---|---|---|
| $f_v$ | 5 | 100kHz |

Those skilled in the art will appreciate that many well-known ways could be used to implement the transfer functions in the blocks of the COM system. The system gain $K$ is maintained constant within the bandwidth of the system.

An alternative advantageous embodiment of the invention is a two-pole compensation of the COM system, such that the in band loop gain is steeper (although less than -12db/octave) for improved feedback compensation by the combined COM modulator and feedback control system. Those skilled in the art will understand that this can e.g. be implemented in the B-block.

Other embodiments of the invention include input filtering and limitation section to control the transfer function and to provide improved clipping characteristics, which may advantageously be of the soft clipping type. In addition the limiter will keep the oscillator running and the control loop in operation. A third advantage of a properly implemented limiter function is that there will not be and lag during recovery from overload. Those skilled in the art will appreciate that many well-known ways to implement such a limiting function.

## Claims

1.  Controlled self-oscillating modulator, comprising a comparator and a power amplification stage for pulse modulation, and a higher order oscillating loop comprising first feedback means and first forward means securing stable oscillating conditions, wherein said first feedback means is arranged to supply a first feedback signal to said first forward means, which is arranged to provide a modulating signal to said comparator, **characterized by**
    current measurement means, arranged to measure a value of a current supplied by said power amplification stage to a load connected to the modulator, said measured value being supplied to said first feedback means,
    wherein said first feedback means has a transfer function adapted to generate said first feedback signal based on said measured value, and said first forward means has a transfer function adapted to generate said modulating signal based on said first feedback signal and an input signal.

2.  Controlled self-oscillating modulator according to claim 1, further including means for feedback of an output voltage from said amplification stage.

3.  Controlled self-oscillating modulator according to claim 2, wherein said first feedback means is connected to said output voltage, said first feedback means being adapted to generate said first feedback signal based on said current value and said voltage.

4.  Controlled self-oscillating modulator according to claim 2, further comprising
    second feedback means connected to said output voltage, adapted to generate a second feedback signal, and second forward means, adapted to supply said first forward block with said input signal based on said second feedback signal and a second signal.

5.  Controlled self-oscillating modulator according to claim 4, wherein said power amplification stage comprises an output filter, and wherein said second feedback means is connected to an output from said output filter.

6.  Controlled self-oscillating modulator according to any of the preceding claims, further comprising limiter means to control the modulation depth.

7.  Controlled self-oscillating modulator according to claim 6, wherein said means for current measurement is adapted to implement protection functions as limitations of peak current and long term current.

8.  Power conversion system, implementing a modulator according to any of the preceding claims.

9.  Power conversion system according to claim 8, used to drive an electrodynamic transducer load directly.

**Patentansprüche**

1. Gesteuerter selbstoszillierender Modulator mit einem Komparator und einer Leistungsverstärkerstufe für Pulsmodulation und mit einer oszillierenden Schleife höherer Ordnung mit ersten Rückkopplungselementen und ersten Vorkopplungselementen, die stabile Oszillationsbedingungen gewährleisten, wobei die ersten Rückkopplungselemente so ausgelegt sind, dass sie ein erstes Rückkopplungssignal an die ersten Vorkopplungselemente liefern, die so ausgelegt sind, dass sie ein modulierendes Signal an den Komparator liefern, **gekennzeichnet durch** Strommessorgane, die so ausgelegt sind, dass sie einen Wert des von der Leistungsverstärkerstufe an eine an den Modulator angeschlossene Last gelieferten Stromes messen, wobei der gemessene Wert an die ersten Rückkopplungselemente geliefert wird,
   wobei die ersten Rückkopplungselemente eine Transferfunktion besitzen, die dafür geeignet ist, auf der Grundlage des gemessenen Wertes das erste Rückkopplungssignal zu liefern, und die ersten Vorkopplungselemente eine Transferfunktion besitzen, die dafür geeignet ist, auf der Grundlage des ersten Rückkopplungssignals und eines Eingangssignals das modulierende Signal zu liefern.

2. Gesteuerter selbstoszillierender Modulator nach Anspruch 1, weiter Mittel für die Rückkopplung einer Ausgangsspannung von der Verstärkerstufe enthaltend.

3. Gesteuerter selbstoszillierender Modulator nach Anspruch 2, worin die ersten Rückkopplungselemente an die benannte Ausgangsspannung angeschlossen sind, während die ersten Rückkopplungselemente dafür ausgelegt sind, auf der Basis des benannten Stromwertes und der benannten Spannung das erste Rückkopplungssignal zu erzeugen.

4. Gesteuerter selbstoszillierender Modulator nach Anspruch 2, weiter umfassend
   zweite, an die benannte Ausgangsspannung angeschlossene Rückkopplungselemente, dazu ausgelegt, ein zweites Rückkopplungssignal zu erzeugen, und
   zweite Vorkopplungselemente, dafür ausgelegt, auf der Basis des zweiten Rückkopplungssignals und eines zweiten Signals den ersten Vorkopplungsblock mit dem benannten Eingangssignal zu versorgen.

5. Gesteuerter selbstoszillierender Modulator nach Anspruch 4, worin die Leistungsverstärkerstufe ein Ausgangsfilter umfasst und worin die zweiten Rückkopplungselemente an einen Ausgang des Ausgangsfilters angeschlossen sind.

6. Gesteuerter selbstoszillierender Modulator nach einem der vorangehenden Ansprüche, weiter Begrenzermittel umfassend, um die Modulationstiefe zu steuern.

7. Gesteuerter selbstoszillierender Modulator nach Anspruch 6, worin die Strommessorgane dafür ausgelegt sind, Schutzfunktionen als Begrenzungen des Spitzenstromes und des Langzeitstromes zu implementieren.

8. Leistungsumsetzungssystem, das einen Modulator nach einem der vorangehenden Ansprüche implementiert.

9. Leistungsumsetzungssystem nach Anspruch 8, dafür verwendet, um eine elektrodynamische Wandlerlast direkt anzusteuern.

**Revendications**

1. Modulateur à auto-oscillation contrôlée, comprenant un comparateur et un étage d'amplification de puissance pour la modulation d'impulsion, et une boucle d'oscillation d'ordre plus élevé comprenant un premier moyen de rétroaction et un premier moyen de transmission qui assurent des conditions d'oscillations stables, dans lequel le premier moyen de rétroaction est disposé pour fournir un premier signal de rétroaction vers ledit premier moyen de transmission, qui est disposé pour fournir un signal de modulation audit comparateur, **caractérisé en ce que**
   un moyen de mesure du courant, disposé pour mesurer une valeur d'un courant délivré par ledit étage d'amplification de puissance à une charge connectée au modulateur, ladite valeur mesurée étant fournie audit premier moyen de rétroaction,
   dans lequel ledit premier moyen de rétroaction a une fonction de transfert adaptée pour générer ledit premier signal de rétroaction en se basant sur ladite valeur mesurée, et ledit premier moyen de transmission a une fonction de transfert adaptée pour générer ledit signal de modulation en se basant sur ledit premier signal de rétroaction et un signal d'entrée.

**2.** Modulateur à auto-oscillation contrôlée selon la revendication 1, incluant en outre un moyen pour la rétroaction d'une tension de sortie dudit étage d'amplification.

**3.** Modulateur à auto-oscillation contrôlée selon la revendication 2, dans lequel ledit premier moyen de rétroaction est connecté à ladite tension de sortie, ledit premier moyen de rétroaction étant adapté pour générer ledit premier signal de rétroaction basé sur ladite valeur de courant et ladite tension.

**4.** Modulateur à auto-oscillation contrôlée selon la revendication 2, comprenant en outre
un deuxième moyen de rétroaction connecté à ladite tension de sortie, adapté pour générer un deuxième signal de rétroaction, et
un deuxième moyen de transmission, adapté pour délivrer audit premier bloc de transmission ledit signal d'entrée basé sur ledit deuxième signal de rétroaction et un deuxième signal.

**5.** Modulateur à auto-oscillation contrôlée selon la revendication 4, dans lequel ledit étage d'amplification de puissance comprend un filtre de sortie, et dans lequel ledit deuxième moyen de rétroaction est connecté à une sortie dudit filtre de sortie.

**6.** Modulateur à auto-oscillation contrôlée selon l'une quelconque des revendications précédentes, comprenant en outre un moyen de limitation pour contrôler la profondeur de modulation.

**7.** Modulateur à auto-oscillation contrôlée selon la revendication 6, dans lequel ledit moyen de mesure du courant est adapté pour mettre en oeuvre des fonctions de protection telles que des limitations de pic de courant et de courant à long terme.

**8.** Système de conversion de puissance, mettant en oeuvre un modulateur selon l'une quelconque des revendications précédentes.

**9.** Système de conversion de puissance selon la revendication 8, utilisé pour exciter directement une charge d'un transducteur électrodynamique.

Fig. 1 (Prior art)

Fig. 2

Controlled Oscillation Modulator (COM)

$V_I$ →

**B** → 22

$V_{DC}$ →

$V_s$

$i_L$ $V_p$

**A** 21

**Load**

## Fig. 3

31

33

$V_c$

**C**

CCOM

$V_s$

**A**

30

32

$V_I$ → **D** $V_d$ → **B** $V_b$ → $V_{ref}$ → $V_s$

$i_L$ →

$V_o$

34

## Fig. 4